(19) Europäisches Patentamt
European Patent Office
Office européen des brevets

(11) **EP 2 237 323 A2**

(12) **EUROPEAN PATENT APPLICATION**

(43) Date of publication:
**06.10.2010 Bulletin 2010/40**

(51) Int Cl.:
***H01L 31/0352*** *(2006.01)*

(21) Application number: **10157003.4**

(22) Date of filing: **19.03.2010**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**
Designated Extension States:
**AL BA ME RS**

(30) Priority: **31.03.2009 US 415267**

(71) Applicant: **General Electric Company
Schenectady, NY 12345 (US)**

(72) Inventors:
• **Korevaar, Bastiaan Arie
Schenectady, NY 12305 (US)**
• **Ahmad, Faisal Razi
Niskayuna, NY 12309 (US)**

(74) Representative: **Bedford, Grant Richard
Global Patent Operation - Europe
GE International Inc.
15 John Adam Street
London WC2N 6LU (GB)**

(54) **Layer for thin film photovoltaics and a solar cell made therefrom**

(57)    A photovoltaic device 100 is provided comprising a layer 200. The layer comprises a plurality of grains 212 separated by grain boundaries 314 wherein the grains are either p-type or n-type. The grain boundaries comprise an active dopant. The active dopant concentration in the grain boundaries is higher than the effective dopant concentration in the grains. The grains and grain boundaries may be of the same type or of the opposite type. Further, when the grain boundaries are n-type the bottom of the grain boundaries may be p-type. A method of making the layer 200 is also disclosed.

FIG. 2

EP 2 237 323 A2

**Description**

The invention relates generally to the field of photovoltaics. In particular, the invention relates to a layer used in solar cells and a solar cell made therefrom.

Solar energy is abundant in many parts of the world year around. Unfortunately, the available solar energy is not generally used efficiently to produce electricity. The cost of conventional solar cells, and electricity generated by these cells, is generally very high. For example, a typical solar cell achieves a conversion efficiency of less than 20 percent. Moreover, solar cells typically include multiple layers formed on a substrate, and thus solar cell manufacturing typically requires a significant number of processing steps. As a result, the high number of processing steps, layers, interfaces, and complexity increase the amount of time and money required to manufacture these solar cells.

Accordingly, there remains a need for an improved solution to the long-standing problem of inefficient and complicated solar energy conversion devices and methods of manufacture.

In one embodiment, a photovoltaic device is provided. The device comprises a layer. The layer comprises a plurality of grains separated by grain boundaries wherein the grains are either p-type or n-type. The grain boundaries comprise an active dopant. The active dopant concentration in the grain boundaries is higher than the effective dopant concentration in the grains.

In another embodiment, is provided a photovoltaic device. The device comprises an absorber layer. The absorber layer comprises cadmium telluride. The absorber layer comprises a plurality of grains separated by grain boundaries wherein the grains are p-type. The grain boundaries comprise an active dopant. The amount of the active dopant is sufficient to make the grain boundaries n-type.

In still yet another embodiment, is provided a photovoltaic device. The device comprises a window layer, wherein the window layer comprises cadmium sulfide.

The window layer comprises a plurality of grains separated by grain boundaries wherein the grains are n-type. The grain boundaries comprise an active dopant. The amount of the active dopant is sufficient to make the grain boundaries n-type with the grain boundaries having a higher active dopant concentration of the n-type when compared to the effective dopant concentration of the n-type in the grains.

In yet another embodiment, is provided a photovoltaic device. The device comprises a layer, wherein the layer comprises a plurality of grains separated by grain boundaries. The grains are either p-type or n-type. The grain boundaries comprise an active dopant. The amount of the active dopant in the grain boundaries is sufficient to make the grain boundaries of a type opposite to that of the type of the grains in the layer. Also the amount of the active dopant in the grain boundaries near the bottom region of the layer is sufficient to allow the grain boundaries in the bottom region to remain of a type similar to the type of the grains while simultaneously having a higher active dopant concentration when compared to the effective dopant concentration in the grains.

In still yet another embodiment, is provided a photovoltaic device. The device comprises an absorber layer, wherein the absorber layer comprises cadmium telluride. The absorber layer comprises a plurality of grains separated by grain boundaries. The grains are p-type. The grain boundaries comprise an active dopant. The amount of the active dopant is sufficient to make the grain boundaries n-type. Also the amount of the active dopant in the grain boundaries near the bottom region of the layer is sufficient to allow the grain boundaries in the bottom region to remain p-type while simultaneously having a higher active dopant concentration when compared to the effective dopant concentration in the grains.

In still yet another embodiment, is provided a method. The method comprises providing a layer in a photovoltaic device. The layer comprises a plurality of grains separated by grain boundaries. The grains are either p-type or n-type. The grain boundaries comprise an active dopant. The active dopant concentration in the grain boundaries is higher than the effective dopant concentration in the grains.

Various features, aspects, and advantages of the present invention will become better understood when the following detailed description is read with reference to the accompanying drawings in which like characters represent like parts throughout the drawings, wherein:

FIG. 1 illustrates a schematic of a photovoltaic device;

FIG. 2 illustrates a layer of a photovoltaic device in accordance with certain embodiments of the present invention;

FIG. 3 illustrates a layer of a photovoltaic device in accordance with certain embodiments of the present invention;

FIG. 4 illustrates a layer of a photovoltaic device in accordance with certain embodiments of the present invention;

FIG. 5 illustrates a layer of a photovoltaic device in accordance with certain embodiments of the present invention;

FIG. 6 illustrates a schematic of a method to make a layer of a photovoltaic device as shown in FIG. 2 in accordance with certain embodiments of the present invention; and

FIG. 7 illustrates a schematic of a method to make a layer of a photovoltaic device as shown in FIG. 5 in accordance with certain embodiments of the present invention.

Cadmium telluride (CdTe) based solar devices known in the art typically demonstrate relatively low power conversion efficiencies, which may be attributed to a relatively low open circuit voltage ($V_{oc}$) in relation to the bandgap of the material. This is due to the fact that the effective carrier concentration in CdTe is too low. Traditionally, the performance of a CdTe-based device has been explained by assigning bulk properties to the CdTe. However, there are increasing indications that the device performance is primarily controlled by the properties of the grain boundaries, and thus bulk properties only present an effective collective value of the whole film forming the solar cell.

Embodiments of the invention described herein address the noted shortcomings of the state of the art. The device described herein fills the needs described above by employing a doping method that will permit the addition of active dopants to the grain boundaries that will result in a layer with controlled grain boundary doping and hence result in higher $V_{oc}$, thereby improving the device efficiency. Appreciating that these doped layers actually act as mini-junctions all through the film, with the junctions being formed between the grain boundaries and the grain, changes the concept of how one can improve these devices.

One or more specific embodiments of the present invention will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present invention, the articles "a," "an," "the," and "said" are intended to mean that there are one or more of the elements. The terms "comprising," "including," and "having" are intended to be inclusive and mean that there may be additional elements other than the listed elements. Moreover, the use of "top," "bottom," "above," "below," and variations of these terms is made for convenience, but does not require any particular orientation of the components unless otherwise stated. As used herein, the terms "disposed over" or "deposited over" or "disposed between" refers to both secured or disposed directly in contact with and indirectly by having intervening layers therebetween.

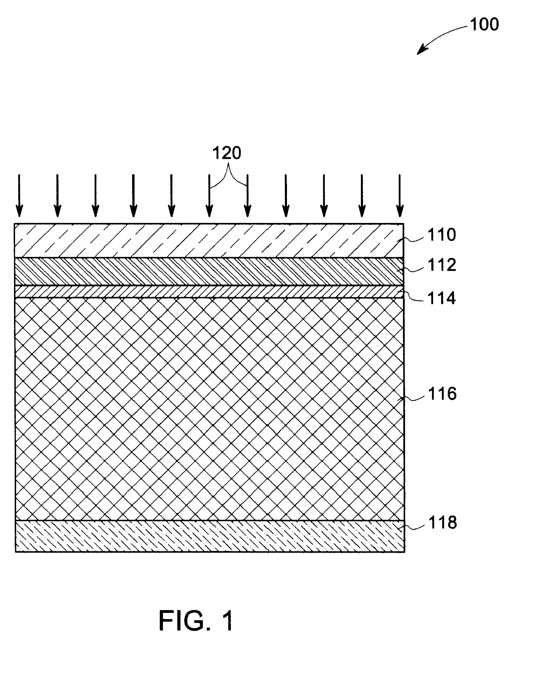

As illustrated in Figure 1, in one embodiment, a photovoltaic device 100 is provided. The device 100 comprises a layer, such as one or more layers 110, 112, 114, 116, and 118. The layer comprises a semiconducting material comprising a plurality of grains separated by grain boundaries, wherein the grains are either p-type or n-type. The grain boundaries comprise an active dopant. The active dopant concentration in the grain boundaries is higher than the effective dopant concentration in the grains.

As used herein the term "active dopant" means that the dopant employed comprises a foreign material different to the material comprising the grains. The foreign material may be considered as impurities willfully introduced in the grain boundaries. A person skilled in the art will appreciate that grains contain inherent manufacturing defects at the grain boundaries and these defects in the grain boundaries may also function as dopants. However, in the context of the current disclosure, these defects are not considered "active dopants." As mentioned above, the active dopant, i.e., is the foreign material added in the grain boundaries to actively dope the grain boundaries. The active dopants in a layer render the grain boundaries either p-type or n-type. As used herein the phrase "active dopant concentration" means the resultant doping concentration of a layer based on both the acceptor states and the donor states that are present in the layer on account of various types of defects and willfully introduced impurities present in the layer. In one embodiment, the defects are inherent in the layers based on the method of manufacturing while the impurities may be introduced in the layers during the manufacturing process as discussed herein. Also, as used herein the phrase "effective dopant concentration" means the resultant doping concentration of a layer based on both the acceptor states and the donor states that are present in a layer on account of various types of defects present in the layer.

In one embodiment, the active dopant concentration in the grain boundaries is sufficient to make the grain boundaries a type opposite to that of the type of the grains in the layer. In one embodiment, the grains are p-type and the grain boundaries are n-type. In another embodiment, the grains are n-type and the grain boundaries are p-type. Alternatively, in some embodiments the grains and grain boundaries are of the same type (p or n).

In one embodiment, the layer is an absorber layer 116. Typically, when light falls on the solar cell 100, electrons in the absorber layer 116 are excited from a lower energy "ground state", in which they are bound to specific atoms in the solid, to a higher "excited state," in which they can move through the solid. Since most of the energy in sunlight and artificial light is in the visible range of electromagnetic radiation, a solar cell absorber should be efficient in absorbing radiation at those wavelengths. In one embodiment, the absorber layer 116 comprises p-type grains and n-type grain boundaries. In another embodiment, the absorber layer 116 comprises n-type grains and p-type grain boundaries. In yet another embodiment, the absorber layer 116 comprises p-type grains and p-type grain boundaries.

In one embodiment, the absorber layer 116 comprises cadmium telluride, cadmium zinc telluride, cadmium sulfur telluride, cadmium manganese telluride, or cadmium magnesium telluride. CdTe is a prominent polycrystalline thin-film material, with a nearly ideal bandgap of about 1.45 electron volts to about 1.5 electron volts. CdTe also has a very high absorptivity. Although CdTe is most often used in photovoltaic devices without being alloyed, it can be alloyed with zinc, magnesium, manganese, and a few other elements to vary its electronic and optical properties. Films of CdTe can be manufactured using low-cost techniques. In one embodiment, the CdTe absorber layer 116 may typically comprise p-type grains and n-type grain boundaries.

The cadmium telluride may, in certain embodiments, comprise other elements from the Group II and Group VI or Group III and Group V that may not result in large bandgap shifts. In one embodiment, the bandgap shift is less than or equal to about 0.1 electron Volts for the absorber layer. In one embodiment, the atomic percent of cadmium in the cadmium telluride is in the range from about 48 atomic percent to about 52 atomic percent. In another embodiment, the atomic percent of tellurium in the cadmium telluride is in the range from about 45 atomic percent to about 55 atomic percent. In one embodiment, the cadmium telluride employed may include a tellurium-rich cadmium telluride, such as a material wherein the atomic percent of tellurium in the tellurium-rich cadmium telluride is in the range from about 52 atomic percent to about 55 atomic percent. In one embodiment, the atomic percent of zinc or magnesium in cadmium telluride is less than about 10 atomic percent. In another embodiment, the atomic percent of zinc or magnesium in cadmium telluride is about 8 atomic percent. In yet another embodiment, the atomic percent of zinc or magnesium in cadmium telluride is about 6 atomic percent. In one embodiment, the CdTe absorber layer 116 may comprise p-type grains and n-type grain boundaries.

In one embodiment, the layer is a window layer 114. The window layer 114, disposed on absorber layer 116, is the junction-forming layer for device 100. The "free" electrons in the absorber layer 116 are in random motion, and so generally there can be no oriented direct current. The addition of the window layer 114, however, induces a built-in electric field that produces the photovoltaic effect.

Materials suitable for use in the window layer 114 include, for example, cadmium sulfide, zinc telluride, zinc selenide, cadmium selenide, cadmium sulfur oxide, copper oxide, or a combination thereof. The atomic percent of cadmium in the cadmium sulfide, in some embodiments, is in range from about 48 atomic percent to about 52 atomic percent. In one embodiment, the atomic percent of sulfur in the cadmium sulfide is in a range from about 45 atomic percent to about 55 atomic percent.

In certain embodiments, the window layer 114 comprises n-type grains and n-type grain boundaries. The n-type doped grain boundaries of the window layer may assist in electron transport to the contact on top of the window layer.

In particular embodiments, absorber layer 116 comprises cadmium telluride and window layer 114 comprises cadmium sulfide, thereby providing a heterojunction interface between the two layers. Typically the window layer 114 acts as an n-type window layer that forms the pn-junction with the p-type absorber layer.

In one embodiment, the layer is a back contact layer 118, which transfers current into or out of device 100, depending on the overall system configuration. Generally, back contact layer 118 comprises a metal, a semiconductor, other appropriately electrically conductive material, or combinations thereof. In one embodiment, the back contact layer 118 comprises a semiconductor comprising p-type grains and p-type grain boundaries. The p-type grain boundaries will assist in transporting the charge carriers between the back contact metal and the p-type semi-conductor layer. In some embodiments, the back contact layer may comprise one or more of a semiconductor selected from zinc telluride (ZnTe), mercury telluride (HgTe), cadmium mercury telluride (CdHgTe), arsenic telluride ($As_2Te_3$), antimony telluride ($Sb_2Te_3$), and copper telluride ($Cu_xTe$).

In one embodiment, the photovoltaic device 100 further comprises a substrate 110 and a front contact layer 112 disposed over the substrate 110. In the illustrated embodiment, window layer 114 is disposed over the front contact layer 112. An absorber layer 116 is disposed over the window layer 114. The window layer 114 comprises a material of the opposite semiconductor type relative to the semiconductor type of the absorber layer. The back contact layer 118 is disposed over the absorber layer and finally a metal layer 122 may then be disposed on the back contact layer for improving the electrical contact.

The configuration of the layers illustrated in FIG. 1 may be referred to as a "superstrate" configuration since the light 120 enters from the substrate 110 and then passes on into the device. Since, in this embodiment the substrate layer 110 is in contact with the front contact layer 112, the substrate layer 110 is generally sufficiently transparent for visible light to pass through the substrate layer 110 and come in contact with the front contact layer 112. Suitable examples of materials used for the substrate layer 110 in the illustrated configuration include glass or a polymer. In one embodiment, the polymer comprises a transparent polycarbonate or a polyimide. The front and the back contact layers are needed to carry the electric current out to an external load and back into the device, thus completing an electric circuit.

In one embodiment, the front contact layer 112 comprises a transparent conductive oxide, examples of which include cadmium tin oxide ($Cd_2SnO_4$), zinc tin oxide ($ZnSnO_x$), indium tin oxide (ITO), aluminum-doped zinc oxide (ZnO:Al), zinc oxide (ZnO), and/or fluorine-doped tin oxide (SnO:F) and combinations of these. In some embodiment, the metal layer may comprise one or more of group IB metal, or a group IIIA metal, or a combination thereof. Suitable non-limiting examples of group IB metals include copper (Cu), silver (Ag), and gold (Au). Suitable non-limiting examples of group IIIA metals (e.g., the low melting metals) include indium (In), gallium (Ga), and aluminum (Al). Other examples of potentially suitable metals include molybdenum and nickel. In various embodiments, the window layer 114, the absorber layer 116, and the back contact layer 118 respectively comprise one or more of the materials previously described for these elements. In one embodiment, the device 100 illustrated in FIG. 1 is a CdTe solar cell. In CdTe solar cells the light enters through the substrate 110 on the frontside (for example, glass), passes through the front contact layer 112 (for example, a transparent conductive oxide (SnO:F)) and the window layer 114 (for example, CdS) to be absorbed by the absorber layer 116 (for example, CdTe), where the light generates electron-hole pairs. Typically as discussed above, the window layer 114 acts as an n-type window layer that forms the pn-junction with the p-type absorber layer.

In an alternative embodiment, a "substrate" configuration comprises a photovoltaic device wherein a back contact layer is disposed on a substrate layer. Further an absorber layer is disposed over the back contact layer. A window layer is then disposed on the absorber layer and a front contact layer is disposed on the window layer. In the substrate configuration, the substrate layer may comprise glass, polymer, or a metal foil. In one embodiment, metals that may be employed to form the metal foil include stainless steel, molybdenum, titanium, and aluminum.

As mentioned above, in one embodiment, the grain boundaries of a layer material, such as one or more layers 110, 112, 114, 116, and 118, are n-type. Suitable active dopants employed to make n-type grain boundaries of CdTe, include a material selected from aluminum, gallium, indium, iodine, chlorine, and bromine. As mentioned above, in one embodiment, the grain boundaries of the layer material are p-type, for example, CdTe can be formed both as an n-type and a p-type semiconductor. Suitable active dopants employed to make p-type grain boundaries include material selected from copper, gold, silver, sodium, bismuth, sulfur, arsenic, phosphorous, and nitrogen.

As mentioned above, the active dopant concentration in the grain boundaries is higher than the effective dopant concentration in the grains. In one embodiment, the active dopant concentration in the grain boundaries is in a range from about $5 \times 10^{16}$ per cubic centimeter to about $10^{19}$ per cubic centimeter. In another embodiment, active dopant concentration in the grain boundaries is in a range from about $5 \times 10^{15}$ per cubic centimeter to about $10^{18}$ per cubic centimeter. In yet another embodiment, active dopant concentration in the grain boundaries is in a range from about $10^{15}$ per cubic centimeter to about $5 \times 10^{17}$ per cubic centimeter. In one embodiment, the effective dopant concentration in the grains is in a range from about $10^{16}$ per cubic centimeter to about $10^{18}$ per cubic centimeter. In another embodiment, the effective dopant concentration in the grains is in a range from about $10^{15}$ per cubic centimeter to about $10^{17}$ per cubic centimeter. In yet another embodiment, the effective dopant concentration in the grains is in a range from about $5 \times 10^{14}$ per cubic centimeter to about $5 \times 10^{16}$ per cubic centimeter.

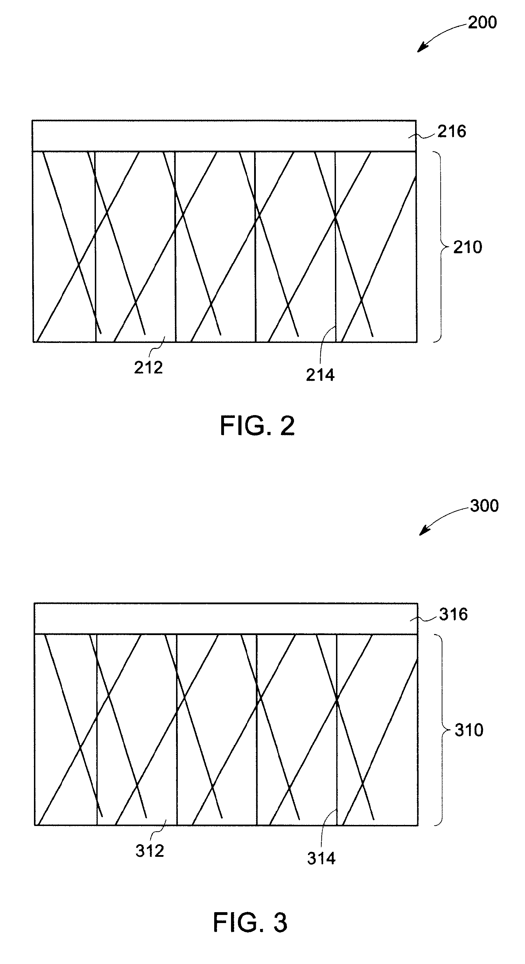

In another embodiment, is provided a photovoltaic device. The device comprises an absorber layer. The absorber layer comprises cadmium telluride. The absorber layer comprises a plurality of grains separated by grain boundaries wherein the grains are p-type. The grain boundaries comprise an active dopant. The amount of the active dopant is sufficient to make the grain boundaries n-type. Referring to FIG. 2, a layer 200 of a photovoltaic device in accordance with certain embodiments of the present invention is illustrated. In the embodiment described in FIG. 2, the layer may comprise an absorber layer 210 formed using CdTe. The absorber layer includes p-type grains 212 and n-type grain boundaries 214. On one side of the absorber layer an n-type window layer 216 is disposed. The n-type layer may be formed using CdS.

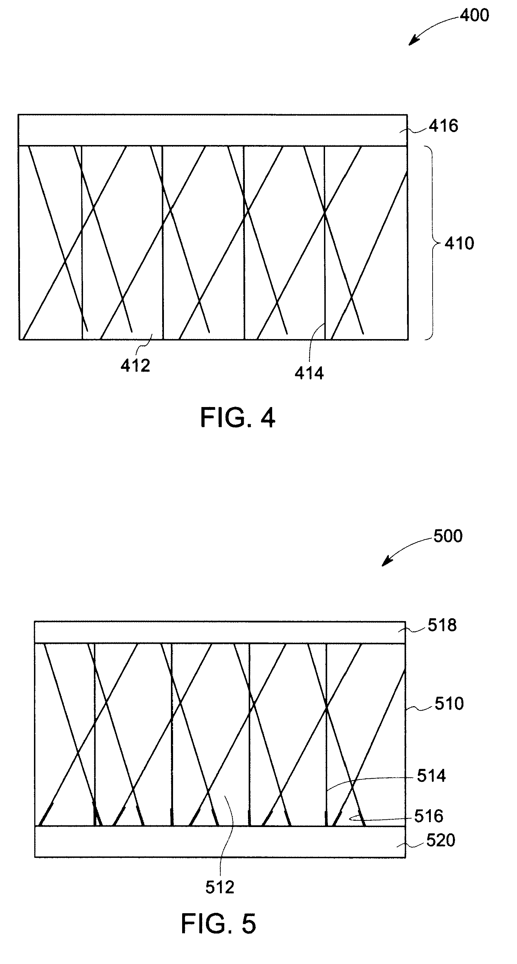

In another embodiment, is provided a photovoltaic device. The device comprises a window layer, wherein the window layer comprises cadmium sulfide. The window layer comprises a plurality of grains separated by grain boundaries wherein the grains are n-type. The grain boundaries comprise an active dopant. The amount of the active dopant is sufficient to make the grain boundaries n-type with the grain boundaries having a higher active dopant concentration of the n-type when compared to the effective dopant concentration of the n-type in the grains. Referring to FIG. 3, a layer 300 of a photovoltaic device in accordance with certain embodiments of the present invention is illustrated. In the embodiment described in FIG. 3, the layer may comprise a window layer 310 formed using CdS. The window layer includes n-type grains 312 and n-type grain boundaries 314. On one side of the window layer a p-type absorber layer 316 is disposed. The p-type absorber layer may be formed using CdTe. Referring to FIG. 4, a layer 400 of a photovoltaic device in accordance with certain embodiments of the present invention is illustrated. In the embodiment described in FIG. 4, the layer may comprise a back contact layer 410 formed using Cu. The back contact layer includes p-type grains 412 and p-type grain boundaries 414. The back contact layer may be disposed on a p-type absorber layer 416. The p-type absorber layer may be formed using CdTe.

Another embodiment is a photovoltaic device. The device comprises a layer, wherein the layer comprises a plurality of grains separated by grain boundaries. The grains are either p-type or n-type. The grain boundaries comprise an active dopant. The amount of the active dopant in the grain boundaries is sufficient to make the grain boundaries of a type opposite to that of the type of the grains in the layer. Also the amount of the active dopant in the grain boundaries near the bottom region of the layer 516, as described in FIG. 5 below, is sufficient to allow the grain boundaries in the bottom region to remain of a type similar to the type of the grains while simultaneously having a higher active dopant concentration when compared to the effective dopant concentration in the grains. Referring to FIG. 5, a layer 500 of a photovoltaic device in accordance with certain embodiments of the present invention is illustrated. In the embodiment described in FIG. 5, the layer may comprise an absorber layer 510 formed using CdTe. The absorber layer includes p-type grains 512 and n-type grain boundaries 514. The amount of the active dopant in the grain boundaries near the bottom region 516 of the layer is sufficient to render the bottom region 516 p-type while simultaneously having a higher active dopant concentration when compared to the effective dopant concentration in the grains 512. In one embodiment, the bottom region 516 of the layer is closer to the rear side of the device where a back contact layer 520 is disposed over the absorber layer 510 of the device. The back contact layer 520 may be p-type formed using a metal, for example copper. On the other side of the absorber layer an n-type window layer 518 is disposed. The n-type window layer may be formed using CdS.

Another embodiment is a photovoltaic device. The device comprises an absorber layer 510, wherein the absorber layer comprises cadmium telluride. The absorber layer comprises a plurality of grains 512 separated by grain boundaries 514. The grains 512 are p-type. The grain boundaries 514 comprise an active dopant. The amount of the active dopant is sufficient to make the grain boundaries n-type. Also, the amount of the active dopant in the grain boundaries near the bottom region of the layer 516 is sufficient to allow the grain boundaries 514 in the bottom region 516 to remain p-type while simultaneously having a higher active dopant concentration when compared to the effective dopant concentration in the grains 512.

Another embodiment is a photovoltaic device. The device comprises an absorber layer 510, wherein the absorber layer comprises cadmium telluride. The absorber layer comprises a plurality of grains 512 separated by grain boundaries 514. The grains 512 are n-type. The grain boundaries comprise an active dopant. The amount of the active dopant is sufficient to make the grain boundaries less n-type than the grains 512 or even p-type, such that hole transport can be along the grain boundaries. Also the amount of the active dopant in the grain boundaries near the bottom region of the layer 516 is sufficient to allow the grain boundaries in the bottom region 516 to remain n-type while simultaneously having a higher active dopant concentration when compared to the effective dopant concentration in the grains 512.

In certain embodiments, the doping concentration along the grain boundary from top to bottom is graded from high concentration of one type say for example n-type in the top, to the high concentration of opposite type say for example p-type in the bottom. In another embodiment the effective dopant concentration along the grain boundaries is graded from one type to the other type when going from one side of the layer to the other side of the layer. When making devices, in which the active dopants are driven into the layer from both sides of the layer, the region where the active dopants of opposite type come in contact, might result in an effectively graded region. When incorporating the active dopants along the grain-boundaries, active dopants of the opposite type can cancel out the effect of each other, which is a kind of self-compensation, resulting in an effective lower dopant concentration. One skilled in the art will appreciate that though the active dopant concentration in a certain region can be higher than in a certain another region, the effective dopant concentration can be lower.

Yet another embodiment is a method for making the devices described above. The method comprises providing a layer such as one or more of layers 110, 112, 114, 116, and 118 in a photovoltaic device 100. The layer comprises a semiconducting material comprising a plurality of grains separated by grain boundaries. The grains are either p-type or n-type. The grain boundaries comprise an active dopant. The active dopant concentration in the grain boundaries is higher than the effective dopant concentration in the grains.

In one embodiment, the method comprises providing an active dopant, and treating the layer in a manner such that the active dopant is diffused into the grain boundaries and remains confined therein. In various embodiments, the diffusion of the active dopant into the grain boundaries may be achieved using methods known to one skilled in the art.

For example, a CdTe device may be made using a wide variety of methods including closed-space sublimation, electro chemical deposition, chemical bath deposition, vapor transport deposition, and other physical or chemical vapor deposition. In one embodiment, the diffusion of dopants from grains into grain boundaries may be achieved by applying a film of the active dopant on the surface of the layer to be doped. The film may contain a controlled concentration of the active dopant. The layer with the film may then be heat treated for incorporating the doping substance into the crystal lattice positions in the layer. For example, in one embodiment, a thin metallic film containing the active dopant may be deposited on the backside of a CdTe device, after CdTe deposition. On heating the sample to a temperature of about 400 degrees Celsius, the active dopants diffuse along the grain boundaries, passivating and actively doping defects within the grain boundaries.

In another embodiment, the active dopants may be deposited within a thin film on top of the CdS layer, before the deposition of CdTe over the CdS layer. During the deposition of the CdTe film, typically at high temperatures, the thin film including the active dopants completely dissolves within the CdTe film, actively doping the grain boundaries of the CdTe film. In yet another embodiment the active dopants may be incorporated as impurities within the CdS film. Incorporating the active dopant in the CdS film can be accomplished by adding the active dopant species to the chemical bath solution out of which the CdS layer is deposited. The deposition may be accomplished either by chemical bath deposition (CBD) or electrochemical deposition. On annealing and deposition at high temperatures, the dopants may leech out of the CdS film and occupy defect regions along the grain boundaries of the CdTe device.

In one embodiment, the diffusion may be achieved by exposing the layer to be doped to a reactive medium comprising the active dopant under controlled temperatures that assist in diffusion of the active dopant in the layer. In one embodiment, this reactive medium could be a plasma medium. The layer may be exposed to a plasma environment. Vapors containing the active dopant from gaseous, liquidus, or solidus precursors may be added to the plasma. The precursor may then dissociate to form various radicals, creating a highly 'chemical' reactive medium that will interact with the layer surface, allowing plasma chemistry at the surface, and resulting diffusion of the active dopants along the grain boundaries. Both low-energy or high-energy plasmas can be used, in which either electron collision or ion-plasma chemistry will result in precursor dissociation. A plasma is a highly reactive medium consisting of electrons and ions, and excited atoms or molecules, carrying enough energy for dissociation of precursors fed into the plasma.

As discussed above, in one embodiment, the layer wherein the active dopant concentration in the grain boundaries is sufficient to make the grain boundaries a type opposite to that of the type of the grains in the layer is an absorber layer. Again, as discussed above, in other embodiments, the active dopant concentration in the grain boundaries is sufficient to make the grain boundaries of the same type as the grains in the layer with the grain boundaries.

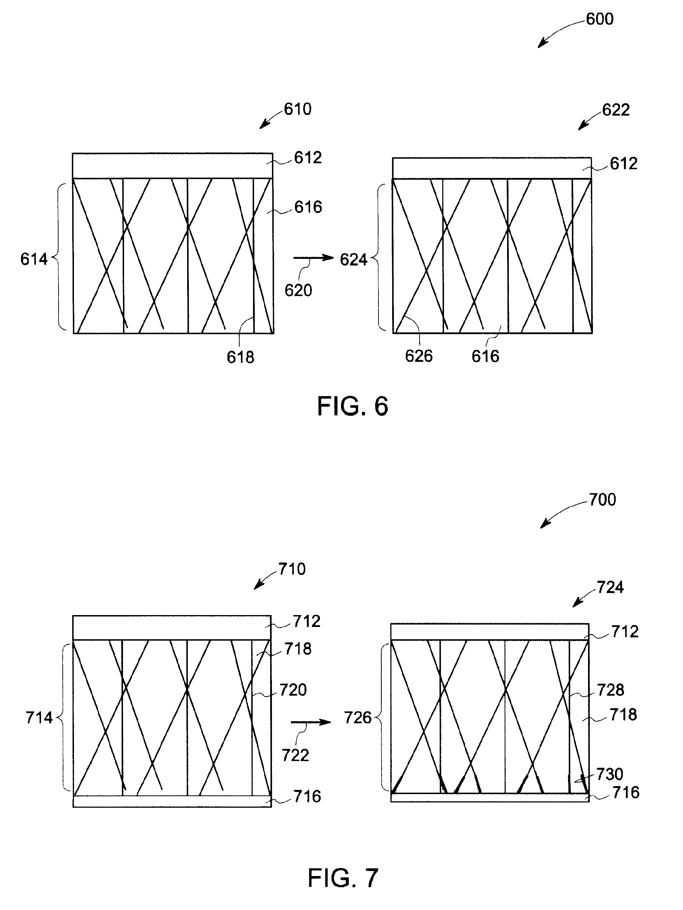

Referring to FIG. 6 a schematic 600 of a method to make a layer as shown in FIG. 2 in accordance with certain embodiments of the present invention is illustrated. In one embodiment, in a first step a layer 610 is formed by disposing an active dopant layer 612 on top of an absorber layer 614. The absorber layer comprises grains 616 and grain boundaries 618. The grains are p-type. The layer is then annealed 620 to drive the active dopant into the grain boundaries resulting in a modified layer 622. The modified layer comprises an active dopant layer with a depleted thickness and a modified absorber layer 624. The modified absorber layer comprises p-type grains 616 and n-type grain boundaries 626. In one embodiment, the absorber layer comprises CdTe. In one embodiment, the active dopant layer comprises a thin metallic film containing the active dopant.

Referring to FIG. 7, a schematic 700 of a method to make a layer in accordance with certain embodiments of the present invention is illustrated. In one embodiment, in a first step a layer 710 is formed by disposing an active dopant layer 712 on top of an absorber layer 714. In a second step a a p-type layer 716 is disposed on the other side of the absorber layer. The absorber layer comprises grains 718 and grain boundaries 720. The grains are p-type. The resultant layer 710 including the active dopant layer, the absorber layer, and the p-type layer is then annealed 722 to drive the active dopant into the grain boundaries and the p-type into the bottom region of the grain boundaries resulting in a modified layer 724. The modified layer comprises an active dopant layer and a p-type layer with a depleted thickness and a modified absorber layer 726. The modified absorber layer comprises p-type grains 718, n-type grain boundaries 728 with the amount of the active dopant in the grain boundaries near the bottom region of the layer sufficient enough to render the bottom region of the grain boundaries p-type 730 while simultaneously having a higher active dopant concentration when compared to the effective dopant concentration in the grains of the absorber layer. In one embodiment, the absorber layer comprises CdTe. In one embodiment, the active dopant layer comprises a thin metallic film containing the active dopant. In one embodiment, the p-type layer comprises copper. In one embodiment, the p-type layer with a depleted thickness may then function as a back contact layer.

Typically, the efficiency of a solar cell is defined as the electrical power that can be extracted from a module divided by the power density of the solar energy incident on the cell surface. Using Figure 1 as a reference, the incident light 120 passes through the substrate 110, front contact layer 112, and window layer 114 before it is absorbed in the absorber layer 116, where the conversion of the light energy to electrical energy takes place via the creation of electron-hole pairs. There are four key performance metrics for photovoltaic devices: (1) Short-circuit current density ($J_{SC}$) is the current density at zero applied voltage (2) Open circuit voltage ($V_{OC}$) is the potential between the anode and cathode with no current flowing. At $V_{OC}$ all the electrons and holes recombine within the device. This sets an upper limit for the work that can be extracted from a single electron-hole pair. (3) Fill factor (FF) equals the ratio between the maximum power that can be extracted in operation and the maximum possible for the cell under evaluation based on its $J_{SC}$ and $V_{OC}$. Energy conversion efficiency ($\eta$) depends upon both the optical transmission efficiency and the electrical conversion efficiency of the device, and is defined as:

$$\eta = J_{SC} \, V_{OC} \, FF/P_S$$

with (4) $P_S$ being the incident solar power. The relationship shown in the equation does an excellent job of determining the performance of a solar cell. However, the three terms in the numerator are not totally independent factors and typically, specific improvements in the device processing, materials, or design may impact all three factors.

The short-circuit current depends on reflection losses, absorption losses in the glass, TCO and the CdS window layers, and the depletion depth of the electric field into the CdTe absorber layer. The minority carrier lifetime, in the case of p-type CdTe electrons, in CdTe is too short to allow a large contribution from the quasi-neutral region of the device and typically only electrons generated within the depletion depth contribute to the photocurrent. Typical depletion depths into the CdTe layer are of the order of about 0.5 micrometer to about 2 micrometer, depending on the effective carrier concentration of the CdTe layer. Charge generated outside this region typically does not contribute to the photocurrent. The open-circuit voltage is determined mainly by the effective carrier concentration of the CdTe layer. As CdTe is a heavily self-compensating material, the p-type carrier concentration of this layer is typically in the range from about $1 \times 10^{14}$ to about $3 \times 10^{14}$ per cubic centimeter, allowing a maximum open-circuit voltage of about 0.85 Volts, whereas the theoretical limit for materials with a bandgap in the 1.45 electron Volts range is slightly above 1 Volt. One skilled in the art will appreciate that the theoretical limit will depend on the carrier concentration. The fill factor for small area CdTe devices is mainly determined by the in-cell series and shunt resistance contributions; the Schottky barrier on the backside of these types of cells, attributable to the disparity between the work functions of the CdTe and the metal materials, can have a large contribution. This Schottky barrier arises from the fact that the electron affinity for CdTe is reported to be somewhere between 4.0 and 4.3 electron volts. As CdTe is a p-type material in most cell designs, this would result in a work function in a range of about 5.0 to about 5.4 electron Volts, depending on the exact position of the Fermi-level. As not many metals have work functions that high, this may typically result in a Schottky barrier.

As discussed above the CdTe layer comprises grains and grain boundaries. In conventional devices, the grains are generally p-type and the grain boundary is thin and lightly doped, and thus mostly depleted by the p-charge in the grains. The defects in the grain boundaries result in decreased current extraction from the cell because there are disconnects generated at the grain boundaries.

The devices known in the art have layers that often are being treated in performance modeling as single crystal layers, though the layers are multi-crystalline. The layers include grains interspaced with grain boundaries. The devices, however, comprise defects in the grain boundaries that compensate for the doping concentration in the grains, resulting in a relatively low effective doping concentration in the range of $1 \times 10^{14}$ to $3 \times 10^{14}$ per cubic centimeter.

As mentioned above, the grain boundary is thin and lightly doped, and thus mostly depleted of charge carriers by the p-charge in the grains. The depletion of charge carriers may be explained as follows. When two semiconductors are placed together, they may interact and electric fields may extend into each other. This extension of the electric fields largely depends on the doping concentration of the material. The extension may be about 1 micron for $10^{15}$ cubic centimeter charge concentration and maybe about 5 nanometers for $10^{19}$ cubic centimeter charge concentration. Thus grain boundaries could be completely depleted of charge if not doped to a very high level. If the grain boundary is doped to varying levels all through the grain boundary, then the electric field strength in the grain boundary may be different from location to location. When the grain boundaries are not actively doped, but rely on doping through defects, the grain boundaries will have different doping concentration at different locations within the grain boundaries. This may result in some regions being slightly n-type and some regions being slightly p-type and thus result in certain locations actually acting as transport barriers. By actively over-doping the grain boundaries, this effect of barriers may be reduced. For example, an electron traveling through the grain boundary will experience significant resistance. However if the grain boundary is appropriately doped with a charge carrier of the type opposite to the type of the charge in the grains then it may be easier for the electron to pass through.

Typically, as discussed above, CdTe films tend to have relatively weak pn-junctions resulting from the p type grains and the depleted grain boundaries. This leads to relatively low Voc. This may be improved by actively doping the grain boundaries such that the grains are p-type and the grain boundaries are n-type. Thus the active doping of the grain boundaries may assist in forming strong pn-junctions all through the device. The introduction of active dopants not only decreases or passivates the defects in the grain boundaries but also assists in improving the current extraction through the grain boundary interfaces. Thus higher Voc can be obtained for these types of devices. By actively doping the grain boundaries of the layers in the devices higher potential efficiencies can be achieved than currently achieved. For example, where appropriately doped CdTe grains in the range of $10^{17}$ cubic centimeter are considered, a relatively low Voc may be assigned for those devices based on a low effective doping level of the grain boundaries. Typically, there are two types of build-in voltages the Voc is typically determined by a horizontal build-in voltage between grains and grain boundaries and a vertical build-in voltage between say for example, the CdS window layer and the CdTe absorber layer, which results from the major p-n junction. The horizontal build-in voltage, which is dependent on the difference in Fermi level in the p-type versus the n-type material, helps to separate electron and holes horizontally. The vertical build-in voltage helps in carrier transportation, which ultimately defines the performance of the device in terms of Voc, Jsc and FF. Further it may also be advantageous to have the bottom region of the grain boundaries in the CdTe layer to be rendered p-type. By making the bottom region p-type a barrier may be formed for the electrons. When the grain boundaries are rendered n-type, the electrons may move to the grain boundaries. If the n-type grain boundaries are in direct contact with the back contact layer, the electrons could leak to the back-contact, causing a significant leakage current, which will lower the Voc. By adding p-type dopants in the grain boundary near the bottom, electrons may not move to the bottom regions of the grain boundaries. Further, rendering the grain boundaries in the bottom more p-type than the grains may assist in hole-collection.

Typically, for CdTe devices, CdS is employed as an n-type layer. If the CdS layer is doped at $10^{17}$ per cubic centimeter and the CdTe is p-type doped at $2 \times 10^{14}$ per cubic centimeter, the theoretical $V_{OC}$ of such a device may be calculated to be about 850 milli Volts, while the theoretical limit based on the bandgap for CdTe is about 1040 milli Volts. As mentioned above, one skilled in the art will appreciate that the theoretical limit depends on the carrier concentration. On the other hand, if the junction is now between the grain boundary and the grain within the CdTe layer, and not between the CdS and the CdTe, the view may differ. The relatively low Voc value is now attributed to the difference between the $10^{17}$ per cubic centimeter p-type grains versus $10^{15}$ per cubic centimeter n-type grain boundaries. Hence, if the doping content of the grain boundaries is increased it can result in an increased Voc.

While only certain features of the invention have been illustrated and described herein, many modifications and changes will occur to those skilled in the art. It is, therefore, to be understood that the appended claims are intended to cover all such modifications and changes as fall within the true spirit of the invention.

Various aspects and embodiments of the present invention are defined by the following numbered clauses:

1. A photovoltaic device, comprising:

a layer, wherein the layer comprises a plurality of grains separated by grain boundaries; wherein the grains are either p-type or n-type; wherein the grain boundaries comprise an active dopant; and wherein the active dopant concentration in the grain boundaries is higher than the effective dopant concentration in the grains.

2. The photovoltaic device as defined in clause 1, wherein the active dopant concentration in the grain boundaries is sufficient to make the grain boundaries a type opposite to that of the type of the grains in the layer.

3. The photovoltaic device as defined in any preceding clause, wherein the grains are p-type and the grain boundaries are n-type.

4. The photovoltaic device as defined in any preceding clause, wherein the grains are n-type and the grain boundaries are p-type.

5. The photovoltaic device as defined in any preceding clause, wherein the layer is an absorber layer.

6. The photovoltaic device as defined in any preceding clause, wherein the absorber layer comprises cadmium telluride, cadmium zinc telluride, cadmium sulfur oxide, cadmium manganese telluride, or cadmium magnesium telluride.

7. The photovoltaic device as defined in any preceding clause, further comprising a substrate layer, a front contact layer disposed over the substrate layer, a window layer disposed over the front contact layer, the absorber layer disposed over the window layer, wherein the window layer comprises a material of the opposite type as that of the absorber layer, and a back contact layer disposed over the absorber layer.

8. The photovoltaic device as defined in any preceding clause, wherein the front contact layer comprises a transparent conductive oxide selected from the group consisting of cadmium tin oxide, zinc tin oxide, indium tin oxide, aluminum-doped zinc oxide, zinc oxide, and/or fluorine-doped tin oxide, and combinations of these.

9. The photovoltaic device as defined in any preceding clause, wherein the substrate comprises glass or polymer.

10. The photovoltaic device as defined in any preceding clause, wherein the layer is a window layer.

11. The photovoltaic device as defined in any preceding clause, wherein the window layer comprises cadmium sulfide, zinc telluride, zinc selenide, cadmium selenide, cadmium sulfur oxide, and or copper oxide.

12. The photovoltaic device as defined in any preceding clause, wherein the layer is a back contact layer.

13. The photovoltaic device as defined in any preceding clause, wherein the back contact layer comprises mercury telluride, zinc telluride, cadmium mercury telluride, arsenic telluride, antimony telluride, and copper telluride.

14. The photovoltaic device as defined in any preceding clause, wherein the amount of the active dopant in the grain boundaries is sufficient to make the grain boundaries of the same type as the grains in the layer with the grain boundaries.

15. The photovoltaic device as defined in any preceding clause, wherein the grains are p-type and the grain boundaries are p-type.

16. The photovoltaic device as defined in any preceding clause, wherein the grains are n-type and the grain boundaries are n-type.

17. The photovoltaic device as defined in any preceding clause, wherein the layer is an absorber layer.

18. The photovoltaic device as defined in any preceding clause, wherein the layer is a window layer.

19. The photovoltaic device as defined in any preceding clause, wherein the layer is a back contact layer.

20. The photovoltaic device as defined in any preceding clause, wherein the active dopant comprises a material selected from aluminum, gallium indium, iodine, chlorine, and bromine.

21. The photovoltaic device as defined in any preceding clause, wherein the active dopant comprises a material selected from copper, gold, silver, sodium, bismuth, sulfur, arsenic, phosphorous, and nitrogen.

22. The photovoltaic device as defined in any preceding clause, wherein a concentration of the active dopant in the grain boundaries is in a range from about $5 \times 10^{16}$ per cubic centimeter to about $10^{19}$ per cubic centimeter.

23. The photovoltaic device as defined in any preceding clause, wherein a concentration of the effective dopant in the grains is in a range from about $10^{16}$ per cubic centimeter to about $10^{18}$ per cubic centimeter.

24. A photovoltaic device, comprising:

an absorber layer, wherein the absorber layer comprises cadmium telluride,
wherein the absorber layer comprises a plurality of grains separated by grain boundaries;
wherein the grains are p-type;
wherein the grain boundaries comprise an active dopant; and

wherein the amount of the active dopant is sufficient to make the grain boundaries n-type.

25. A photovoltaic device, comprising:

a window layer, wherein the window layer comprises cadmium sulfide,
wherein the window layer comprises a plurality of grains separated by grain boundaries;
wherein the grains are n-type;
wherein the grain boundaries comprise an active dopant; and
wherein the amount of the active dopant is sufficient to make the grain boundaries n-type with the grain boundaries having a higher active dopant concentration of the n-type when compared to effective dopant concentration of the n-type in the grains.

26. A photovoltaic device, comprising:

a layer, wherein the layer comprises a plurality of grains separated by grain boundaries;
wherein the grains are either p-type or n-type;
wherein the grain boundaries comprise an active dopant;
wherein the amount of the active dopant in the grain boundaries is sufficient to make the grain boundaries of a type opposite to that of the type of the grains in the layer; and
wherein the amount of the active dopant in the grain boundaries near a bottom region of the layer is sufficient to allow the grain boundaries in the bottom region to remain of a type similar to the type of the grains while simultaneously having a higher active dopant concentration in the grain boundaries when compared to the effective dopant concentration in the grains.

27. A photovoltaic device, comprising:

an absorber layer, wherein the absorber layer comprises cadmium telluride,
wherein the absorber layer comprises a plurality of grains separated by grain boundaries;
wherein the grains are p-type;
wherein the grain boundaries comprise an active dopant;
wherein the amount of the active dopant is sufficient to make the grain boundaries n-type; and
wherein the amount of the active dopant in the grain boundaries near the bottom region of the layer is sufficient to allow the grain boundaries in the bottom region to remain p- type while simultaneously having a higher active dopant concentration when compared to the effective doping concentration in the grains.

28. A method comprising:

provide a layer in a photovoltaic device, wherein the layer comprises a plurality of grains separated by grain boundaries, wherein the grains are either p-type or n-type, wherein the grain boundaries comprise an active dopant, and wherein the active dopant concentration in the grain boundaries is higher than the effective dopant concentration in the grains.

29. The method as defined in clause 26, wherein providing the layer comprises:

providing an active dopant; and treating the layer in a manner such that the active dopant is diffused into the grain boundaries.

30. The method as defined in clause 28 or 29, wherein the layer is an absorber layer.

31. The method as defined in any of clauses 28 to 30, wherein providing the active dopant comprises incorporation the active dopant as impurities in the window layer.

32. The method as defined in any of clauses 28 to 31, wherein the window layer is deposited on the layer using chemical bath deposition or electrochemical deposition.

33. The method as defined in any of clauses 28 to 32, wherein the amount of the active dopant in the grain boundaries is sufficient to make the grain boundaries a type opposite to that of the type of the grains in the layer.

34. The method as defined in any of clauses 28 to 33, wherein the layer is an absorber layer.

35. The method as defined in any of clauses 28 to 34, wherein the amount of the active dopant in the grain boundaries is sufficient to make the grain boundaries of the same type as the grains in the layer with the grain boundaries.

36. The method as defined in any of clauses 28 to 35, wherein the layer is an absorber layer.

37. The method as defined in any of clauses 28 to 36, wherein the layer is a window layer.

38. The method as defined in any of clauses 28 to 37, wherein the layer is a back contact layer.

**Claims**

1. A photovoltaic device (100), comprising:

a layer (200), wherein the layer comprises a plurality of grains (212) separated by grain boundaries (314); wherein the grains are either p-type or n-type; wherein the grain boundaries comprise an active dopant; and wherein the active dopant concentration in the grain boundaries is higher than the effective dopant concentration in the grains.

2. The photovoltaic device (100) as defined in claim 1, wherein the active dopant concentration in the grain boundaries (314) is sufficient to make the grain boundaries a type opposite to that of the type of the grains in the layer.

3. The photovoltaic device (100) as defined in any preceding claim, wherein the layer comprises an absorber layer, a window layer, or a back contact layer.

4. The photovoltaic device (100) as defined in any preceding claim, wherein the amount of the active dopant in the grain boundaries (314) is sufficient to make the grain boundaries of the same type as the grains in the layer with the grain boundaries.

5. The photovoltaic device (100) as defined in any preceding claim, wherein the layer (200) comprises an absorber layer, a window layer, or a back contact layer.

6. A photovoltaic device (100), comprising:

an absorber layer, wherein the absorber layer comprises cadmium telluride, wherein the absorber layer comprises a plurality of grains separated by grain boundaries; wherein the grains (212) are p-type; wherein the grain boundaries (314) comprise an active dopant; and wherein the amount of the active dopant is sufficient to make the grain boundaries n-type.

7. A photovoltaic device (100), comprising:

a window layer, wherein the window layer comprises cadmium sulfide, wherein the window layer comprises a plurality of grains separated by grain boundaries; wherein the grains (212) are n-type; wherein the grain boundaries comprise an active dopant; and wherein the amount of the active dopant is sufficient to make the grain boundaries n-type with the grain boundaries having a higher active dopant concentration of the n-type when compared to effective dopant concentration of the n-type in the grains.

8. A photovoltaic device (100), comprising:

a layer (200), wherein the layer comprises a plurality of grains separated by grain boundaries; wherein the grains are either p-type or n-type; wherein the grain boundaries comprise an active dopant; wherein the amount of the active dopant in the grain boundaries is sufficient to make the grain boundaries of a type opposite to that of the type of the grains in the layer; and wherein the amount of the active dopant in the grain boundaries (214) near a bottom region of the layer is sufficient to allow the grain boundaries in the bottom region to remain of a type similar to the type of the grains while simultaneously having a higher active dopant concentration in the grain boundaries when compared to the effective dopant concentration in the grains.

9. A photovoltaic device (100), comprising:

an absorber layer, wherein the absorber layer comprises cadmium telluride, wherein the absorber layer (200) comprises a plurality of grains separated by grain boundaries; wherein the grains are p-type; wherein the grain boundaries comprise an active dopant; wherein the amount of the active dopant is sufficient to make the grain boundaries n-type; and wherein the amount of the active dopant in the grain boundaries near the bottom region of the layer is sufficient to allow the grain boundaries in the bottom region to remain p- type while simultaneously having a higher active dopant concentration when compared to the effective doping concentration in the grains.

10. A method comprising:

providing a layer (200) in a photovoltaic device (100), wherein the layer comprises a plurality of grains (212) separated by grain boundaries (314), wherein the grains are either p-type or n-type, wherein the grain boundaries comprise an active dopant, and wherein the active dopant concentration in the grain boundaries is higher than the effective dopant concentration in the grains (212).

FIG. 1

200

216

210

212

214

**FIG. 2**

300

316

310

312

314

**FIG. 3**

400

416

410

412 414

## FIG. 4

500

518

510

514

516

520

512

## FIG. 5

FIG. 6

FIG. 7